# EUROPÄISCHE PATENTSCHRIFT

(11) **EP 0 857 011 B1**
(45) Veröffentlichungstag und Bekanntmachung des Hinweises auf die Patenterteilung: **22.09.2004**
(21) Anmeldenummer: 97121485.3
(22) Anmeldetag: 06.12.1997
(51) Int. Cl.: H05K 5/00, H05K 9/00, H05K 7/20

(54) **Elektrisches Gerät, insbesondere Schalt- und Steuergerät für Kraftfahrzeuge**
Electrical device especially switchgear and control device for a motor vehicle
Appareil électrique, notamment appareil de commutation et dispositif de commande pour vehicle automobile

(30) Priorität: 30.01.1997 DE 29701502 U
(43) Veröffentlichungstag der Anmeldung: 05.08.1998
(73) Patentinhaber: ROBERT BOSCH GMBH, 70442 Stuttgart (DE)
(72) Erfinder: Grass, Ansgar, 77652 Offenburg (DE)

(56) Entgegenhaltungen:
- WO-A-93/14614
- DE-A- 4 243 180
- DE-A- 4 305 793
- DE-A- 19 511 487
- US-A- 5 440 450

## Beschreibung

### Stand der Technik

Die Erfindung geht aus von einem elektrischen Gerät nach der Gattung des Hauptanspruchs.

Bei derartigen aus der DE 42 18 112 A1 bekannten elektrischen Geräten ist die Leiterplatte zwischen einem haubenartigen Gehäusedeckel und einem ebenfalls haubenartigen Gehäuseboden eingesetzt. Sowohl Gehäusedeckel als auch Gehäuseboden haben einen umlaufenden Rand der im Bereich des Außenrandes der Leiterplatte flächig auf dieser aufliegt. Durch entsprechende Verbindung von Gehäusedeckel und Leiterplatte einerseits und Leiterplatte und Gehäuseboden andererseits wird ein sandwichartiger Aufbau erreicht.

Eine derartige Anordnung verlangt einen nicht unerheblichen Material- und Fertigungsaufwand, da drei unterschiedliche Bauteile hergestellt und zusammengebaut werden müssen.

Es ist weiterhin aus der DE 44 34 349 A1 bekannt, daß die Leiterplatte als Gehäusedeckel auf einem umlaufenden Gehäusesteg aufliegt und von gehäuseseitig angeformten federnden Haken gehalten ist.

Die Nutzung der Leiterplatte als Gehäusedeckel führt zu der Einsparung eines Gehäuseteils. Jedoch hat die Leiterplatte hierbei eine rein mechanische Schutzfunktion, aber keine Abschirmfunktion für etwaige Störstrahlung.

### Vorteile der Erfindung

Das erfindungsgemäße elektrische Gerät mit den kennzeichnenden Merkmalen des Hauptanspruchs hat demgegenüber den Vorteil, daß die Leiterplatte durch die elektrische Potentialanbindung (Masseanbindung) mit der Gehäusewanne zur Abschirmung von Störstrahlung dient. Dadurch wird die elektromagnetische Verträglichkeit erheblich verbessert. Die Leiterplatte ist ferner wärmeleitend mit der Gehäusewanne verbunden, so daß die durch Leistungsbauelemente produzierte Wärme an die Gehäusewanne abgeleitet wird.

Weitere Vorteile und vorteilhafte Weiterbildungen ergeben sich aus der Beschreibung und den Unteransprüchen.

### Zeichnung

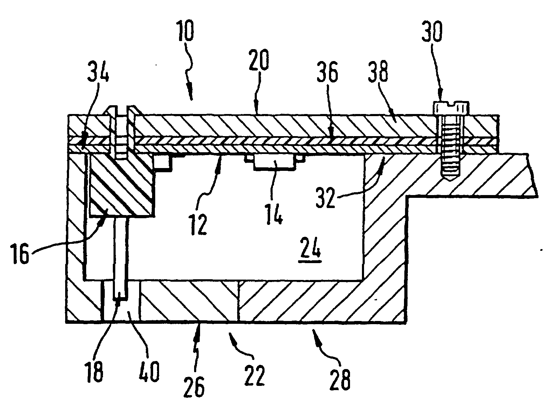

Ein Ausführungsbeispiel der Erfindung ist in der Zeichnung dargestellt und in der nachfolgenden Beschreibung näher erläutert. Es zeigt Figur 1 einen Querschnitt durch ein erfindungsgemäßes elektrisches Gerät in vereinfachter Darstellung.

### Beschreibung des Ausführungsbeispiels

Das elektrische Schalt- oder Steuergerät hat eine Leiterplatte 10 auf deren Unterseite 12 eine elektronische Schaltung aufgebracht ist, von der nur eines von beliebig vielen elektronischen Bauelementen 14 und ein SMD-Stecker 16 mit Stiftkontakt 18 dargestellt sind. Die Leiterbahnen verlaufen in einer Leiterschicht 34, die beispielsweise aus einer bedruckten Leiterfolie besteht. Die Bauelemente 14 können als SMD-Bauelemente (Surface Mounted Device) ausgeführt sein. Die Oberseite 20 bzw. Außenseite der Leiterplatte 10 ist von dem Gehäuseinnenraum weggerichtet und hat die Funktion eines Gehäusedeckels für eine Gehäusewanne 26. Die Gehäusewanne 26 ist hier aus zwei Teilen geformt: einerseits aus einer Vertiefung 24 eines metallischen Motorgetriebegehäuses 28, andererseits aus einem Ergänzungsteil 22 zur Vervollständigung der Gehäusewanne 26.

Das Ergänzungsteil 22 weist einen Durchbruch 40 auf, durch den die Anschlußverbindungen zur bestückten Unterseite 12 der Leiterplatte 10 gelegt werden können. Die Gehäusewanne 26 kann teilweise oder ganz aus einem metallischen, strom- und wärmeleitenden Material gefertigt sein. Die Leiterplatte 10 ist mittels mindestens einer Schraube 30 an einem metallischen Teil der Gehäusewanne 26, hier mit dem Motorgetriebegehäuse 28, lösbar befestigt. Die Auflageflächen 32 der (Masse-) Leiterbahnen in der Leiterschicht 34 der Leiterplatte 10 sind leitend mit diesem metallischen Teil verbunden. Die Auflageflächen 32 stellen die Masseverbindung zum Motorgetriebegehäuse 28 her und sorgen gleichzeitig für einen guten Wärmeübergang. Bei geeigneter Gestaltung der Masseleitungen in der Leiterschicht 34 bilden diese eine elektromagnetische Abschirmung. Bei Verwendung von Kunststoffschrauben 30 liegt wegen einer Isolierschicht 36 der Leiterplatte 10 kein Potential auf der unbestückten Oberseite 20 der Leiterplatte 10.

Bei der Verwendung einer dreilagigen Leiterplatte 10, beispielsweise IMS (Insulate Metallic Substrate), mit einer metallischen Basisschicht 38 aus z.B. Aluminium oder Kupfer und bei Verwendung elektrisch leitender Schrauben 30 wird die Oberseite 20 des Gehäusedeckels ebenfalls auf Massepotential gehalten und kann anstelle der Leiterschicht 34 zur elektromagnetischen Abschirmung verwendet werden. Bei der Wahl der Leiterplatte 10 ist zu berücksichtigen, daß die Basisschicht 38 oder Isolierschicht 36 genügende mechanische Stabilität aufweist.

Anstelle von Schrauben 30 kann die Leiterplatte 10 mit Klemmen, Federn oder Ansätzen an der Gehäusewanne befestigt werden.

## Patentansprüche

1. Elektrisches Gerät, insbesondere Schalt- oder Steuergerät für Kraftfahrzeuge, mit einem eine Gehäusewanne (26) abdekkenden Gehäusedeckel und mindestens einer mit elektronischen Bauelementen (14) bestückbaren Leiterplatte (10), wobei die Leiterplatte (10) als Gehäusedeckel auf dem Rand der Gehäusewanne (26) aufliegt, **dadurch gekennzeichnet, daß** mindestens eine elektrisch leitende Schicht (34, 38) der Leiterplatte (10) zur elektrischen Potentialanbindung und/oder Wärmeanbindung der Schicht (34, 38) mit der Gehäusewanne (26) mit dieser leitend verbunden ist.

2. Gerät nach Anspruch 1, **dadurch gekennzeichnet, daß** eine Vertiefung (24) an einem Motorgetriebegehäuse (28), vorzugsweise aus Aluminium oder Magnesium, mindestens einen Teil der Gehäusewanne (26) bildet.

3. Gerät nach Anspruch 1, **dadurch gekennzeichnet, daß** die Leiterplatte (10) dreilagig aus einer Basisschicht (38), insbesondere aus Aluminium, Kupfer oder Stahl, einer Isolierschicht (36) und einer Leiterschicht (34), insbesondere einer bedruckten Leiterfolie, gebildet ist.

4. Gerät nach Anspruch 1, **dadurch gekennzeichnet, daß** die Leiterplatte (10) an der Gehäusewanne (26) lösbar befestigt ist, insbesondere durch Schrauben, Klemmen, Federn oder Ansätze.

5. Gerät nach Anspruch 1, **dadurch gekennzeichnet, daß** die Leiterplatte (10) in SMD-Technik (Surface Mounted Device) bestückt ist.

6. Gerät nach Anspruch 1, **dadurch gekennzeichnet, daß** die Leiterplatte (10) auf der der Gehäusewanne (26) zugewandten Seite bestückt ist.

## Claims

1. Electrical device, in particular switching or control device for motor vehicles, having a housing lid covering a housing trough (26) and at least one printed circuit board (10) which can be populated with electronic components (14), the printed circuit board (10) resting on the edge of the housing trough (26) in the form of a housing lid, **characterized in that** at least one electrically conductive layer (34, 38) of the printed circuit board (10) is conductively connected to the housing trough (26) for the purpose of providing electrical potential bonding and/or thermal bonding between the layer (34, 38) and said housing trough (26).

2. Device according to Claim 1, **characterized in that** a depression (24) in an engine gearbox housing (28), preferably made of aluminium or magnesium, forms at least part of the housing trough (26).

3. Device according to Claim 1, **characterized in that** the printed circuit board (10) is in the form of three layers comprising a base layer (38), in particular made of aluminium, copper or steel, an insulating layer (36) and a conductor layer (34), in particular a flexible printed circuit.

4. Device according to Claim 1, **characterized in that** the printed circuit board (10) is fixed detachably to the housing trough (26), in particular using screws, clamps, springs or attachment fittings.

5. Device according to Claim 1, **characterized in that** the printed circuit board (10) is populated using SMD technology (surface mounted devices).

6. Device according to Claim 1, **characterized in that** the printed circuit board (10) is populated on the side which faces the housing trough (26).

## Revendications

1. Appareil électrique, notamment appareil de commande ou de commutation pour un véhicule automobile, comportant un couvercle couvrant un boîtier en forme de cuvette (26) et au moins une plaque de circuit imprimé (10) susceptible de recevoir des composants électroniques (14), la plaque de circuit (10) s'appuyant comme couvercle de boîtier sur le bord du boîtier en forme de cuvette (26),
**caractérisé en ce qu'**
au moins une couche électroconductrice (34, 38) de la plaque imprimée (10) est reliée de façon conductrice au boîtier en forme de cuvette (26), pour une mise au potentiel électrique et/ou une liaison de conduction thermique de la couche (34, 38) avec le boîtier.

2. Appareil selon la revendication 1,
**caractérisé en ce qu'**
une cavité (24) d'un boîtier de transmission de moteur (28), notamment en aluminium ou en magnésium, constitue au moins une partie du boîtier en forme de cuvette (26).

3. Appareil selon la revendication 1,
**caractérisé en ce que**
la plaque imprimée (10) est une plaque à trois couches comprenant une couche de base (38), notamment en aluminium, cuivre ou acier, une couche isolante (36) et une couche conductrice (34) notamment un film conducteur imprimé.

4. Appareil selon la revendication 1,
**caractérisé en ce que**
la plaque de circuit (10) est fixée de manière amovible au boîtier en forme de cuvette (26), notamment par vissage, pince, ressort ou bossage.

5. Appareil selon la revendication 1,
**caractérisé en ce que**
la plaque de circuit (10) est garnie en composants selon la technique SMD (composants montés en surface).

6. Appareil selon la revendication 1,
**caractérisé en ce que**
la plaque de circuit (10) reçoit les composants sur son côté tourné vers le boîtier en forme de cuvette (26).
